# EUROPÄISCHE PATENTSCHRIFT

(11) **EP 3 640 896 B1**
(45) Veröffentlichungstag und Bekanntmachung des Hinweises auf die Patenterteilung: **14.02.2024**
(21) Anmeldenummer: 19188577.1
(22) Anmeldetag: 26.07.2019
(51) Int. Cl.: G07C 9/00, E05B 81/76, H03K 17/97, H01Q 1/32, H04B 5/00

(54) **FAHRZEUGTÜRGRIFF MIT NAHFELD-KOMMUNIKATIONSELEKTRONIK**
VEHICLE DOOR HANDLE WITH NEAR FIELD COMMUNICATION ELECTRONICS
POIGNÉE DE PORTE DE VÉHICULE POURVUE D'ÉLECTRONIQUE DE COMMUNICATION DE CHAMP PROCHE

(30) Priorität: 18.10.2018 DE 102018125922
(43) Veröffentlichungstag der Anmeldung: 22.04.2020
(73) Patentinhaber: HUF Hülsbeck & Fürst GmbH & Co. KG, 42551 Velbert (DE)
(72) Erfinder: Chabrowski, Christian, 45472 Mülheim (DE)
(74) Vertreter: Zenz Patentanwälte Partnerschaft mbB

(56) Entgegenhaltungen:
- WO-A1-2017/009073
- DE-A1-102013 102 701
- Meinke H: "Sensor-Messtechnik", , 1 October 2012 (2012-10-01), pages 1-11, XP055835772, Retrieved from the Internet: URL:https://mb-bachelor.htw-berlin.de/file s/Stg/MB/Versuchsanleitungen_Messtechnik/S ensor.pdf [retrieved on 2021-08-30]

## Beschreibung

Die Erfindung betrifft einen Fahrzeugtürgriff für Kraftfahrzeuge, wobei der Fahrzeugtürgriff eine Handhabe aufweist, die über einen damit gekoppelten Befestigungsabschnitt an einem Fahrzeug montierbar ist.

Die Handhabe des Fahrzeugtürgriffes weist ein Gehäuse auf, in dem eine Nahfeld-Kommunikationselektronik aufgenommen ist. Diese Nahfeld-Kommunikationselektronik enthält einen Schwingkreis mit einer Spule. Eine Steuerschaltung ist mit der Nahfeld-Kommunikationselektronik gekoppelt. Wenn die Steuerschaltung die Nahfeld-Kommunikationselektronik in einem Kommunikationsmodus ansteuert, wird die Spule des Schwingkreises als Sende-Empfangsspule für eine Nahfeld-Kommunikation betrieben.

Fahrzeugtürgriffe der genannten Art sind in der Technik bekannt. Beispielsweise offenbart das Dokument DE 10 2013 102 701 A1 eine Türgriffanordnung für Fahrzeuge, wobei in dem Fahrzeugtürgriff sowohl ein kapazitiver Näherungssensor als auch eine Nahfeld-Kommunikationselektronik in Gestalt einer NFC(Near Field Communication)-Sende-Empfangseinheit aufgenommen sind.

Über eine solche Nahfeld-Kommunikationselektronik können Daten zwischen einem externen Datenträger, beispielsweise einer Karte mit einem NFC-Transponder oder einem elektronischen Mobilgerät (insbesondere einem Smartphone) und der türgriffseitigen Nahfeld-Kommunikationselektronik ausgetauscht werden, sofern beide Kommunikationspartner ausreichen aneinander angenähert werden. Insbesondere für Schließfunktionen können Autorisierungsinformationen vom nahfeldkommunikationstauglichen Mobilgerät oder einem sonstigen Datenträger an das Fahrzeug übermittelt werden und in Abhängigkeit von der Überprüfung dieser Daten werden Berechtigungen und Zugriffe auf das Fahrzeug gewährt.

Sowohl der Aufbau von Nahfeld-Kommunikationseinrichtungen, insbesondere von NFC-Kommunikationseinrichtungen als auch deren Ansteuerungs- und Betriebsprotokolle sind bekannt. NFC ist dabei eine Sonderform von RFID (Radio-Frequency Identification), die nur über kurze Distanzen <10 cm funktioniert, eine Frequenz von 13,56MHz nutzt und verschlüsselt kommunizieren kann. Eine Nahfeldkommunikation findet immer zwischen genau zwei Teilnehmern statt. Dabei muss mindestens ein Teilnehmer ein aktives Gerät sein, im Rahmen dieser Erfindung ist die Nahfeld-Kommunikationseinrichtung im Türgriff als aktives Gerät ausgebildet. Dieses aktive Gerät erzeugt ein hochfrequentes Magnetfeld. Das andere Gerät kann ein passives Gerät sein, z.B. die Schlüsselkarte für ein Fahrzeug. Dieses Gerät benötigt keine eigene Energiequelle (es kann jedoch ohne weiteres auch ein aktives Gerät sein) sondern nur einen eigenen Schwingkreis (Antenne), der in etwa auf 13,56MHz abgestimmt ist. Das Magnetfeld des aktiven Gerätes induziert in dort eine Spannung - beide Geräte sind dann induktiv gekoppelt. Zur Datenübertragung kann ein Gerät seinen Schwingkreis variieren (Lastmodulation). Eine veränderte induktive Last registriert das aktive Gerät - es auf diese Weise Daten ausgetauscht werden. Da die Technik bekannt ist wird diesbezüglich auf die Standardisierungsvorgaben und die Fachliteratur verwiesen.

Es ist den bekannten Nahfeld-Kommunikationselektroniken gemein, dass eine Spule, beispielsweise eine Drahtspule oder Leiterspule auf einer Platine, in einem Schwingkreis betrieben wird und der Datenaustausch durch Variationen der Betriebsparameter auf Sender- und Empfängerseite übermittelt werden.

Zur Verbesserung der Kommunikation gilt grundsätzlich, dass eine Spule mit ausreichender Größe, insbesondere mit ausreichendem Spulenquerschnitt anzustreben ist, wobei dies dem sehr begrenzten Platzangebot in einem Fahrzeugtürgriff zuwiderläuft. Soll in dem Fahrzeugtürgriff außerdem noch eine Sensorik zur Erfassung von manuellen Griffbetätigungen angeordnet werden müssen häufig Kompromisse bezüglich der Ausdehnung der Kommunikationselektronik und der Sensorik bezüglich einer Griffbetätigung eingegangen werden.

Der Erfindung liegt die Aufgabe zugrunde, einen Türgriff mit verbesserter Nahfeld-Kommunikation und Erfassung der Griffbetätigung zur Verfügung zu stellen.

Diese Aufgabe wird durch einen Fahrzeugtürgriff mit den Merkmalen des Patentanspruches 1 sowie ein Verfahren mit den Merkmalen des Patentanspruches 6 gelöst.

Der erfindungsgemäße Fahrzeugtürgriff der eingangs genannten Art sieht vor, über die Steuerschaltung die Nahfeld-Kommunikationselektronik oder Bestandteile dieser Nahfeld-Kommunikationselektronik, welche zumindest die Spule enthalten, in einem weiteren Betriebsmodus, nämlich einem Sensormodus anzusteuern. Während der Betrieb der Nahfeld-Kommunikationselektronik und der zugeordneten Spule im Kommunikationsmodus als Sende-Empfangseinrichtung bekannt ist, kann dieser Kommunikationsmodus erfindungsgemäß deaktiviert werden und die Spule der Nahfeld-Kommunikationselektronik kann im Sensormodus als induktiver Sensor angesteuert werden. Dazu ist im Bereich der Spule, beispielsweise im Bereich einer Projektion des Spulenquerschnittes auf das Innere des umgebenden Gehäuses, senkrecht zu der Spulenachse, ein metallisches Bauteil angeordnet. Das metallische Bauteil ist dabei mit dem Gehäuse der Handhabe gekoppelt, so dass es bei Verformung des Gehäuses bewegbar ist. Greift ein Benutzer auf die Handhabe zu und übt eine Kraft auf die Handhabe aus, so wird eine geringfügige Verformung des Gehäuses bewirkt und damit das metallische Bauteil im Inneren des Gehäuses bewegt, während die Spule ortsfest im Griff verbleibt. Diese relative Lageänderung des metallischen Bauteils gegenüber der Spule der Nahfeld-Kommunikationselektronik kann als Sensorsignal ausgewertet werden, sofern die Induktivität der Spule überwacht wird. Dazu nimmt in diesem Sensormodus, in welchem die Induktivität zur Erfassung von Verformungen des Gehäuses betrieben wird, die Steuerschaltung wiederholt Messungen der Induktivität der Spule vor und kann so Verformungen des Gehäuses erfassen. In Abhängigkeit von den erfassten Induktivitätswerten erzeugt die Steuerschaltung ein Betätigungssignal, welches auf eine Betätigung des Fahrzeugtürgriffes durch manuelle Manipulation durch einen Benutzer hinweist.

Ein und dieselbe Spule wird gemäß der Erfindung also einerseits in einem Kommunikationsmodus als Sende-/Empfangsspule für eine Nahfeld-Kommunikation verwendet und in einem anderen Modus, in welchem der Kommunikationsmodus zeitweise ausgeschaltet ist, wird die Spule als induktiver Sensor betrieben, in welchem die Induktivität der Spule wiederholt gemessen wird. Die Art der Messung der Induktivität kann beliebig erfolgen, beispielsweise durch Frequenzkontrolle des Schwingkreises.

Die beiden Betriebsmodi, einerseits der Kommunikationsmodus und andererseits der Sensormodus, können zeitlich wiederholt abwechselnd aktiviert werden (zeitliches Multiplexen), es kann jedoch auch vorgesehen sein, dass der Sensormodus erst aktiviert wird, wenn eine erfolgreiche Legitimationsprüfung über eine Nahfeld-Kommunikation durchgeführt wurde. Greift also beispielsweise ein Benutzer auf ein Fahrzeug zu und legitimiert sich mit einem Datenträger über Nahfeld-Kommunikation unter Kommunikationswirkung der Einrichtung im Türgriff, kann nachfolgend der Kommunikationsmodus deaktiviert werden und der Sensormodus aktiviert werden, um eine anschließende händische Betätigung des Benutzers am Fahrzeugtürgriff zu erfassen.

Vorzugsweise ist das metallische Bauteil eine auf der Gehäuseinnenseite aufgebrachte metallische Schicht. Eine solche metallische Schicht kann durch Aufsprühen eines metallischen Lacks oder Anbringung einer entsprechenden Folierung oder Aufkleben eines metallischen Bleches gebildet werden. Eine solche Schicht ist auf der Innenseite des Gehäuses keiner mechanischen Abnutzung oder Umwelteinflüssen ausgesetzt und ist einfach zu montieren und günstig in der Herstellung.

In einer bevorzugten Gestaltung der Erfindung ist die Spule auf einer im Gehäuse angeordneten Platine als Leiterschleife ausgebildet.

Eine solche Ausbildung der Spule als Leiterbahn auf einer Platine stellt bei ortsfester und verschiebesicherer Anordnung der Platine im Gehäuse des Fahrzeugtürgriffes sicher, dass die Spule jederzeit in einer definierten und reproduzierbaren Ausrichtung und Position im Inneren der Handhabe aufgenommen ist. Außerdem ist die Fertigung einer solchen Spule als Bestandteil der Leiterbahnen einer gefertigten Platine besonders kostengünstig.

In einer vorteilhaften Ausgestaltung der Erfindung ist die Steuerschaltung mit dem metallischen Bauteil elektrisch gekoppelt und derart ausgebildet, dass sie das metallische Bauteil im Sensorbetrieb, also bei Betrieb der Nahfeld-Kommunikationseinrichtung im Sensormodus, auf ein erstes elektrisches Potenzial legt.

Die Steuerschaltung ist über ansteuerbare Komponenten so mit dem metallischen Bauteil gekoppelt, dass eine Vorgabe eines elektrischen Potenzials für das metallische Bauteil über die Steuerschaltung möglich ist. Bei Potenzialvorgabe für des metallische Bauteil wird die Beeinflussung der Induktivität der Spule durch das potenzialfeste metallische Bauteil deutlich erhöht, so dass Lageveränderungen des metallischen Bauteils gegenüber der Spule besser detektiert werden können. Die Potenzialvorgabe bewirkt eine deutliche Modifikation der Feldlinien des Spulenfeldes gegenüber einem metallischen Bauteil ohne Potenzialvorgabe (floating).

Es ist besonders bevorzugt, wenn bei dem Fahrzeugtürgriff der vorstehend genannten Art die Steuerschaltung außerdem so ausgebildet ist, dass sie das metallische Bauteil bei Betrieb der Nahfeld-Kommunikationseinrichtung im Kommunikationsmodus ohne Potenzialvorgabe betreibt. Das Betreiben ohne Potenzialvorgabe bedeutet, dass eine Entkopplung des metallischen Bauteils von Bezugspotenzialen und Betriebspotenzialen, also mit float-Potenzial erfolgt. Allgemein ist unter float-Potenzial zu verstehen, dass keine definierte Potenzialbeziehung des metallischen Bauteils gegenüber übrigen Komponenten vorliegt und insbesondere keine galvanische Kopplung mit Masse oder Betriebsspannungen erfolgt. Die Spule der Nahfeld-Kommunikationselektronik wird bei einer potenzialfreien Schaltung (also bei undefiniertem Potenzial des metallischen Bauteils) in ihrem Sende-Empfangsbetrieb durch das metallische Bauteil nur geringfügig gestört. Das Spulenfeld kann sich aufgrund der Potenzialfreiheit des metallischen Bauteils in ausreichender Weise in den Bereich vor der Spule und in den Außenbereich der Handhabe ausdehnen und auf diese Weise für die Nahfeld-Kommunikation zur Verfügung stehen.

Gemäß dieser Gestaltung der Erfindung wird im Sensormodus ein Potenzial des metallischen Bauteils vorgegeben, im Kommunikationsmodus wird jedoch das metallische Bauteil potenzialfrei gelegt. Damit wird das metallische Bauteil zu einem ansteuerbaren Bestandteil und die Wirksamkeit insbesondere des Sensormodus erhöhenden Bauteils.

Das erfindungsgemäße Verfahren wirkt analog zu der vorgenannten Einrichtung. Es wird unter Verwendung eines Fahrzeugtürgriffes mit Nahfeld-Kommunikationseinrichtung die Spule der Nahfeld-Kommunikationselektronik in der üblichen Weise zur Nahfeld-Kommunikation eingesetzt oder, in zeitlichem Wechsel, als Sensoreinrichtung mit der Spule als induktivem Sensor. Dabei wird die Induktivität der Spule wiederholt gemessen und Änderungen der Induktivität können auf eine Betätigung der Handhabe des Fahrzeugtürgriffes hindeuten, da dann das Gehäuse der Handhabe verformt wird und ein mit der Handhabe gekoppeltes metallisches Bauteil in seiner Lage gegenüber der Spule verändert wird. Diese Lageveränderung führt zu detektierbaren Veränderungen der Induktivität der Spule und mit dem Verfahren kann dann ein und dieselbe Einrichtung mit derselben Spule sowohl zur Nahfeld-Kommunikation als auch als induktiver Sensor verwendet werden.

Die Erfindung wird nun anhand der beiliegenden Zeichnungen näher erläutert.

Die Figur 1a zeigt eine Außenansicht eines Fahrzeugtürgriffes gemäß einer ersten Ausführungsform der Erfindung in einer ersten Ansicht;
Figur 1b zeigt den Fahrzeugtürgriff aus Figur 1a in einer zweiten Ansicht;
Figur 2a zeigt eine schematische Schnittansicht des Fahrzeugtürgriffes aus Figur 1a;
Figur 2b zeigt eine schematische teiltransparente Ansicht des Fahrzeugtürgriffes aus Figur 1b;
Figur 3a zeigt schematisch die Nutzung der ersten Ausführungsform in einem Kommunikationsmodus;
Figur 3b zeigt schematisch die Nutzung der ersten Ausführungsform in einem Sensormodus.

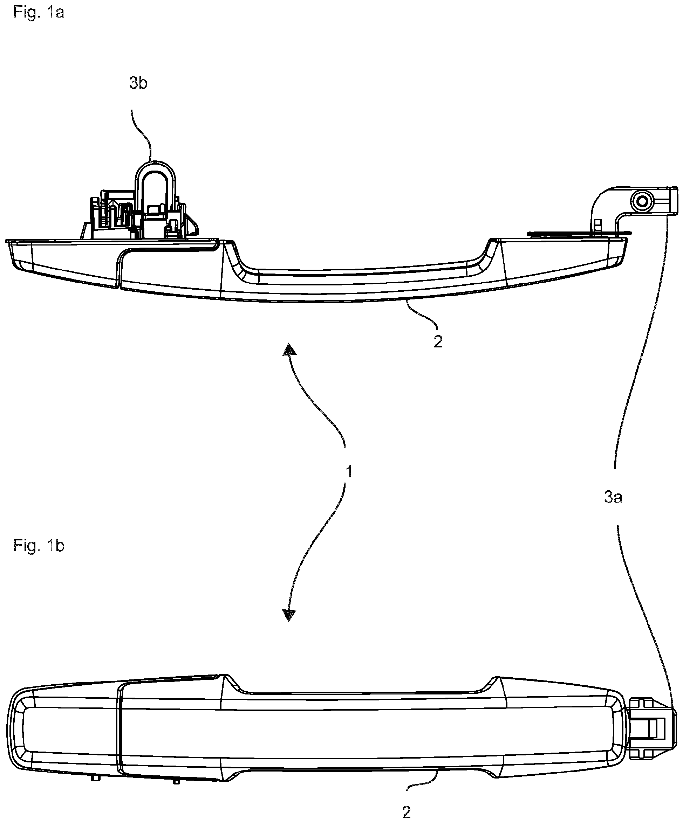

Figur 1a und 1b zeigen in zwei verschiedenen Ansichten einen Fahrzeugtürgriff 1, wie er gemäß seiner Außengestaltung in einem ersten Ausführungsbeispiel der Erfindung realisiert ist. Eine Handhabe 2 ist mit zwei Befestigungsabschnitten 3a, 3b gekoppelt. Mit diesen Befestigungsabschnitten 3a, 3b, die bei Montage des Fahrzeugtürgriffes 1 durch Aussparungen in einem Türblech (nicht gezeigt) geschoben werden, kann der Türgriff 1 mit Befestigungsmitteln an der Tür festgelegt werden, so dass die Handhabe 2 außerhalb des Türbleches verbleibt und für einen Benutzer zugreifbar ist.

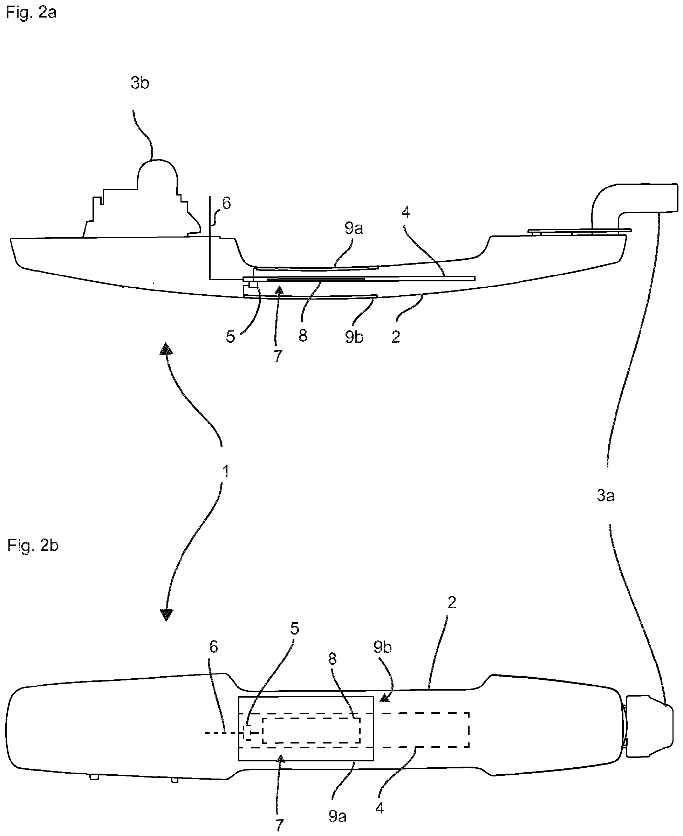

Die Figuren 2a und 2b zeigen den Fahrzeugtürgriff in einer teildurchsichtigen schematischen Darstellung. In diesen Darstellungen ist das Innere des Gehäuses der Handhabe 2 sichtbar, so dass die darin aufgenommenen elektronischen Funktionskomponenten dargestellt sind. Eine Platine 4 ist in dem Gehäuse der Handhabe 2 aufgenommen. Auf der Platine 4 ist eine Steuerschaltung 5 angeordnet, die über Leitungen 6 mit einem Fahrzeugsystem gekoppelt sein kann. Auf der Platine 4 ist außerdem eine Nahfeld-Kommunikationselektronik 7 angeordnet, die eine Spule 8 aufweist. Die Spule 8 ist als Leiterschleife auf der Platine 4 ausgebildet und bildet so eine Induktivität, die in einem Schwingkreis der Nahfeld-Kommunikationselektronik 7 zur Kommunikation nutzbar ist. Die Nahfeld-Kommunikationselektronik ist zu einer Kommunikation gemäß dem NFC-Standard ausgebildet, wobei der Schwingkreis gemäß den Spezifikationen auf eine Frequenz von etwa 13,56 MHz abgestimmt ist.

Zu beiden Seiten von der Nahfeld-Kommunikationselektronik 7 und damit auch zu beiden Seiten von der Spule 8 sind auf der Innenseite des Gehäuses der Handhabe 2 Metallschichten 9a und 9b aufgebracht. Diese sind elektrisch mit der Steuereinrichtung 5 gekoppelt, welche die Metallschichten 9a und 9b entweder auf ein vorgegebenes Potenzial legen kann oder potenzialfrei (floating) schalten kann. Schaltet die Steuereinrichtung 5 die metallischen Bauteile 9a und 9b potenzialfrei, steht die Nahfeld-Kommunikationselektronik 7 unter Steuerung der Steuereinrichtung 5 zur Nahfeld-Kommunikation zur Verfügung. In diesem Kommunikationsmodus stören die potenzialfreien Metallschichten 9a und 9b den Sende-/Empfangsbetrieb der Spule 8 nicht in einer Weise, dass die Nahfeld-Kommunikation unterbunden würde. Werden die metallischen Bauteile 9a und 9b jedoch mit einem vorgegebenen Potenzial belegt, was unter Steuerung der Steuereinrichtung 5 erfolgt, um die Vorrichtung in den Sensorbetrieb zu versetzen, so wird der Sende-Empfangsbetrieb der Spule 8 weitgehend unterbunden und die Induktivität der Spule 8 ist maßgeblich von dem Abstand der metallischen Bauteile 9a und 9b von der Spule 8 abhängig. Wird die Handhabe in diesem Sensorbetrieb durch Krafteinwirkung verformt, insbesondere durch Zug oder Druck, ändern sich die Abstände der metallischen Bauteile 9a und 9b zu der Spule 8 und damit ändert sich die Induktivität der Spule 8. Diese Änderung der Induktivität wird von der Steuereinrichtung 5 erkannt und es kann ein Bestätigungssignal über die Leitungen 6 an ein Fahrzeugsystem ausgegeben werden.

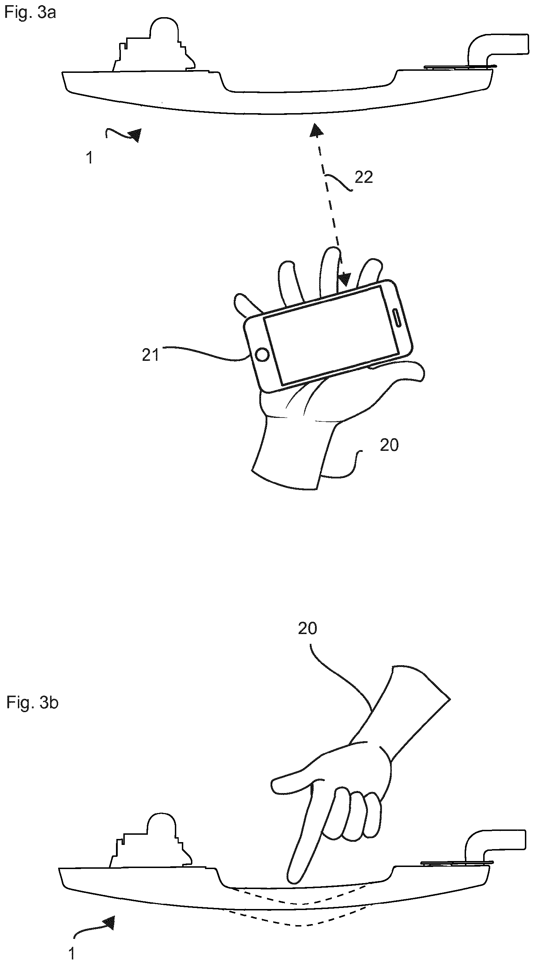

In Figur 3a ist schematisch der Kommunikationsmodus der Einrichtung dargestellt. Ein Benutzer 20 nähert sich mit einem NFC-Datentransporter 21, in diesem Fall einem Smartphone, dem Fahrzeugtürgriff 1. Befindet sich der NFC-Datenträger 21 in wenigen Zentimetern Abstand vor dem Fahrzeugtürgriff 1 so ist unter Steuerung der Steuereinrichtung 5 eine Datenkommunikation 22 gemäß dem bekannten NFC-Standard zwischen der Nahfeld-Kommunikationselektronik in dem Fahrzeugtürgriff 1 und dem NFC-Datenträger 21 möglich. Ist die Autorisierung gegenüber dem Fahrzeug durch erfolgreichen Datenaustausch und Prüfung der Daten von dem NFC-Datenträger 21 an das Fahrzeug erfolgt, so schaltet die Steuereinrichtung 5 die Elektroden 9a und 9b auf ein vorgegebenes Potenzial, so dass eine weitere NFC-Kommunikation zu diesem Zeitpunkt nicht länger möglich ist, jedoch die Spule 8 im Inneren des Fahrzeugtürgriffes 1 als induktiver Sensor eingesetzt wird. Übt ein Benutzer 20, wie in Figur 3b dargestellt, einen verformenden Kraftaufwand auf den Fahrzeugtürgriff 1 aus, so wird dadurch die Lage der metallischen Bauteile 9a und 9b gegenüber der Spule 8 verändert, die Induktivität der Spule 8 ändert sich und ein Betätigungssignal für den Türgriff kann generiert werden.

Die verschiedenen Betriebsmodi für die Spule der Nahfeld-Kommunikationseinrichtung, also einerseits der Kommunikationsbetrieb und andererseits der Sensorbetrieb, können mit zeitlichem Multiplexing ausgeführt werden, alternativ kann der Sensorbetrieb auch erst nach erfolgreicher Kommunikation aktiviert werden.

Während die Anordnung des metallischen Bauteils im inneren des Griffes im vorstehenden Beispiel beschrieben wurde, kann das metallische Bauteil auch in einer Griffwandung oder an der Außenseite des Griffes platziert sein. Es muss lediglich sichergestellt sein, dass das metallische Bauteil im Erfassungsbereich der Spule liegt, wenn diese als induktiver Sensor betrieben wird.

## Patentansprüche

1. Fahrzeugtürgriff (1) mit einer Handhabe (2) und wenigstens einem mit der Handhabe (2) gekoppelten Befestigungsabschnitt zur Montage der Handhabe (2) an einem Fahrzeug,
wobei die Handhabe (2) ein Gehäuse und eine in dem Gehäuse aufgenommene Nahfeld-Kommunikationselektronik aufweist, wobei die Handhabe (2) ausgebildet ist, dass bei deren Betätigung das Gehäuse verformt wird, wobei die Nahfeld-Kommunikationselektronik (7) einen Schwingkreis mit einer Spule (8) aufweist und wobei eine Steuerschaltung (5) mit der Nahfeld-Kommunikationselektronik gekoppelt ist,
wobei die Steuerschaltung (5) zur Ansteuerung der Nahfeld-Kommunikationselektronik in einem Kommunikationsmodus ausgebildet ist, wobei die Spule (8) als Sende-/Empfangsspule (8) für eine Nahfeld-Kommunikation betreibbar ist,
wobei das Gehäuse in einem Bereich, welcher der Spule (8) gegenüberliegt, mit wenigstens ein metallisches Bauteil (9a, 9b) aufweist, wobei das metallische Bauteil ausgebildet ist, seine Lage gegenüber der Spule (8) zu verändern, wenn das Gehäuse verformt wird,
wobei die Steuerschaltung (5) zur zeitweisen Deaktivierung des Kommunikationsmodus und zur Ansteuerung der Spule (8) in einem Sensormodus ausgebildet ist, wobei die Steuerschaltung (5) ausgebildet ist, in dem Sensormodus wiederholt Messungen der Induktivität der Spule (8) vorzunehmen, um Verformungen des Gehäuses zu erfassen,
wobei die Steuerschaltung (5) ausgebildet ist, bei Ansteuerung der Spule (8) im Sensormodus in Abhängigkeit von der Induktivität der Spule (8) ein Betätigungssignal bereitzustellen.

2. Fahrzeugtürgriff (1) nach Anspruch 1, wobei das metallische Bauteil (9a, 9b) eine auf der Gehäuseinnenseite oder der Gehäuseaußenseite aufgebrachte metallische Schicht ist.

3. Fahrzeugtürgriff (1) nach einem der vorangehenden Ansprüche, wobei die Spule (8) auf einer im Gehäuse angeordneten Platine als Leiterschleife ausgebildet ist.

4. Fahrzeugtürgriff (1) nach einem der vorangehenden Ansprüche, wobei die Steuerschaltung (5) mit dem metallischen Bauteil (9a, 9b) elektrisch gekoppelt ist und derart ausgebildet ist, dass sie das metallische Bauteil bei Betrieb der Nahfeld-Kommunikationseinrichtung in dem Sensormodus auf ein erstes elektrisches Potenzial legt.

5. Fahrzeugtürgriff (1) nach Anspruch 4, wobei die Steuerschaltung (5) derart ausgebildet ist, dass sie das metallische Bauteil (9a, 9b) bei Betrieb der Nahfeld-Kommunikationseinrichtung in dem Kommunikationsmodus potenzialfrei, floating, legt.

6. Verfahren zur Nahfeld-Kommunikation und Detektion von Betätigungen an einem Fahrzeugtürgriff (1) mit einer Handhabe (2) und wenigstens einem mit der Handhabe (2) gekoppelten Befestigungsabschnitt zur Montage der Handhabe (2) an einem Fahrzeug,
wobei die Handhabe (2) ein Gehäuse und eine in dem Gehäuse aufgenommene Nahfeld-Kommunikationselektronik aufweist, wobei bei Betätigung der Handhabe das Gehäuse verformt wird,
wobei die Nahfeld-Kommunikationselektronik einen Schwingkreis mit einer Spule (8) aufweist und wobei eine Steuerschaltung (5) mit der Nahfeld-Kommunikationselektronik gekoppelt ist,
wobei die Nahfeld-Kommunikationselektronik zur Durchführung einer Nahfeld-Kommunikation unter Kontrolle der Steuerschaltung (5) in einem Kommunikationsmodus betrieben wird, in welchem die Spule (8) als Sende-/Empfangsspule (8) betrieben wird,
wobei ein metallisches Bauteil mit dem Gehäuse in einem Bereich gekoppelt wird, welcher der Spule (8) gegenüberliegt, so dass das metallische Bauteil bei Verformung des Gehäuses relativ zu der Spule (8) bewegt wird,
wobei die Steuerschaltung (5) zeitweise den Kommunikationsmodus deaktiviert und die Spule (8) in einem Sensormodus ansteuert, wobei die Steuerschaltung (5) wiederholt Messungen der Induktivität der Spule (8) vornimmt, um Verformungen des Gehäuses zu erfassen,
wobei die Steuerschaltung (5) in Abhängigkeit von der Induktivität der Spule (8) ein Betätigungssignal bereitstellt.

7. Verfahren nach Anspruch 6, wobei als metallisches Bauteil auf der Gehäuseinnenseite eine metallische Schicht aufgebracht wird.

8. Verfahren nach einem der Ansprüche 6 oder 7, wobei als Spule (8) eine im Gehäuse angeordnete Platine als Leiterschleife ausgebildet wird.

9. Verfahren nach einem der Ansprüche 6 bis 8, wobei die Steuerschaltung (5) mit dem metallischen Bauteil gekoppelt wird und das metallische Bauteil bei Betrieb der Nahfeld-Kommunikationseinrichtung in dem Sensormodus auf ein erstes elektrisches Potenzial gelegt wird.

10. Verfahren nach einem der Ansprüche 6 bis 9, wobei die Steuerschaltung (5) das metallische Bauteil bei Betrieb der Nahfeld-Kommunikationseinrichtung in dem Kommunikationsmodus auf float-Potenzial, potenzialfrei, legt.

## Claims

1. Vehicle door handle (1) with a grip section (2) and at least one fastening section coupled to the grip section (2) for mounting the grip section (2) on a vehicle,
wherein the grip section (2) has a housing and near-field communication electronics accommodated in the housing, wherein the grip section (2) is designed such that the housing is deformed when it is actuated, wherein the near-field communication electronics (7) has an oscillating circuit with a coil (8) and wherein a control circuit (5) is coupled to the near-field communication electronics,
wherein the control circuit (5) is designed to control the near-field communication electronics in a communication mode, wherein the coil (8) can be operated as a transmit/receive coil (8) for near-field communication,
wherein the housing has at least one metallic component (9a, 9b) in a region which faces the coil (8), wherein the metallic component is designed to change its position relative to the coil (8) when the housing is deformed,
wherein the control circuit (5) is designed for temporarily deactivating the communication mode and for activating the coil (8) in a sensor mode, wherein the control circuit (5) is designed to repeatedly measure the inductance of the coil (8) in the sensor mode in order to detect deformations of the housing,
wherein the control circuit (5) is designed to provide an actuation signal as a function of the inductance of the coil (8) when the coil (8) is controlled in sensor mode.

2. Vehicle door handle (1) according to claim 1, wherein the metallic component (9a, 9b) is a metallic layer applied to the inside or outside of the housing.

3. Vehicle door handle (1) according to one of the preceding claims, wherein the coil (8) is formed as a conductor loop on a circuit board arranged in the housing.

4. Vehicle door handle (1) according to one of the preceding claims, wherein the control circuit (5) is electrically coupled to the metallic component (9a, 9b) and is designed in such a way that it contacts the metallic component to a first electrical potential during operation of the near-field communication device in the sensor mode.

5. Vehicle door handle (1) according to claim 4, wherein the control circuit (5) is designed in such a way that it makes the metallic component (9a, 9b) potential-free, floating, during operation of the near-field communication device in the communication mode.

6. Method for near-field communication and detection of actuations on a vehicle door handle (1) with a grip section (2) and at least one fastening section coupled to the grip section (2) for mounting the grip section (2) on a vehicle,
wherein the grip section (2) has a housing and a near-field communication electronics unit accommodated in the housing, wherein the housing is deformed when the handle is actuated, wherein the near-field communication electronics unit has an oscillating circuit with a coil (8) and wherein a control circuit (5) is coupled to the near-field communication electronics unit,
wherein the near-field communication electronics are operated in a communication mode in which the coil (8) is operated as a transmitting/receiving coil (8) for carrying out near-field communication under control of the control circuit (5), wherein a metallic component is coupled to the housing in a region which is opposite the coil (8), so that the metallic component is moved relative to the coil (8) when the housing is deformed,
wherein the control circuit (5) temporarily deactivates the communication mode and controls the coil (8) in a sensor mode, wherein the control circuit repeatedly measures the inductance of the coil (8) in order to detect deformations of the housing,
wherein the control circuit (5) provides an actuation signal as a function of the inductance of the coil (8).

7. Method according to claim 6, wherein a metallic layer is applied to the inside of the housing as a metallic component.

8. Method according to one of claims 6 or 7, wherein the coil (8) is a printed circuit board arranged in the housing as a conductor loop.

9. Method according to one of claims 6 to 8, wherein the control circuit (5) is coupled to the metallic component and the metallic component is applied to a first electrical potential when the near-field communication device is operating in the sensor mode.

10. Method according to one of claims 6 to 9, wherein the control circuit (5) sets the metallic component to float potential, potential-free, during operation of the near-field communication device in the communication mode.

## Revendications

1. Poignée de porte de véhicule (1) comprenant une manette (2) et au moins une section de fixation couplée à la manette (2) pour le montage de la manette (2) sur un véhicule,
où la manette (2) comprend un boîtier et une électronique de communication en champ proche logée dans le boîtier,
la manette (2) étant conçue de manière à ce que le boîtier soit déformé lorsqu'elle est actionnée,
où l'électronique de communication en champ proche (7) présente un circuit oscillant avec une bobine (8) et où un circuit de commande (5) est couplé à l'électronique de communication en champ proche,
où le circuit de commande (5) est conçu pour commander l'électronique de communication en champ proche dans un mode de communication, la bobine (8) pouvant fonctionner comme bobine d'émission/réception (8) pour une communication en champ proche,
où le boîtier comprend au moins un composant métallique (9a, 9b) dans une zone qui est opposée à la bobine (8), le composant métallique étant conçu pour changer sa position par rapport à la bobine (8) lorsque le boîtier est déformé,
le circuit de commande (5) étant conçu pour désactiver temporairement le mode de communication et pour commander la bobine (8) dans un mode capteur, le circuit de commande (5) étant conçu pour effectuer de manière répétée des mesures de l'inductance de la bobine (8) dans le mode capteur afin de détecter des déformations du boîtier,
le circuit de commande (5) étant conçu pour fournir un signal d'actionnement en fonction de l'inductance de la bobine (8) lors de la commande de la bobine (8) en mode capteur.

2. Poignée de porte de véhicule (1) selon la revendication 1, où le composant métallique (9a, 9b) est une couche métallique appliquée sur la face intérieure du boîtier ou sur la face extérieure du boîtier.

3. Poignée de porte de véhicule (1) selon l'une quelconque des revendications précédentes, la bobine (8) étant réalisée sous forme de boucle conductrice sur une platine disposée dans le boîtier.

4. Poignée de porte de véhicule (1) selon l'une quelconque des revendications précédentes, où le circuit de commande (5) est couplé électriquement au composant métallique (9a, 9b) et est configuré de manière à placer le composant métallique à un premier potentiel électrique lors du fonctionnement du dispositif de communication en champ proche dans le mode capteur.

5. Poignée de porte de véhicule (1) selon la revendication 4, où le circuit de commande (5) est conçu de telle sorte qu'il met le composant métallique (9a, 9b) hors potentiel, flottant, dans le mode de communication lorsque le dispositif de communication en champ proche fonctionne.

6. Procédé de communication en champ proche et de détection d'actionnements sur une poignée de porte de véhicule (1) comprenant une manette (2) et au moins une section de fixation couplée à la manette (2) pour monter la manette (2) sur un véhicule,
où la manette (2) comprend un boîtier et une électronique de communication en champ proche logée dans le boîtier,
le boîtier étant déformé lors de l'actionnement de la manette,
où l'électronique de communication en champ proche présente un circuit oscillant avec une bobine (8) et où un circuit de commande (5) est couplé à l'électronique de communication en champ proche,
où, pour effectuer une communication en champ proche sous le contrôle du circuit de commande (5), l'électronique de communication en champ proche fonctionne dans un mode de communication où la bobine (8) fonctionne comme une bobine d'émission/réception (8),
où un composant métallique est couplé au boîtier dans une zone qui est opposée à la bobine (8), de sorte que le composant métallique est déplacé par rapport à la bobine (8) lorsque le boîtier est déformé,
le circuit de commande désactivant temporairement le mode de communication et commandant la bobine (8) dans un mode de détection, le circuit de commande effectuant des mesures répétées de l'inductance de la bobine (8) afin de détecter des déformations du boîtier,
le circuit de commande (5) fournissant un signal d'actionnement en fonction de l'inductance de la bobine (8).

7. Procédé selon la revendication 6, où une couche métallique est appliquée sur la face intérieure du boîtier en tant que composant métallique.

8. Procédé selon l'une quelconque des revendications 6 ou 7, où une platine disposée dans le boîtier est réalisée sous forme de boucle conductrice en tant que bobine (8).

9. Procédé selon l'une quelconque des revendications 6 à 8, où le circuit de commande (5) est couplé au composant métallique et le composant métallique est placé à un premier potentiel électrique lors du fonctionnement du dispositif de communication en champ proche dans le mode capteur.

10. Procédé selon l'une quelconque des revendications 6 à 9, où le circuit de commande (5) place le composant métallique à un potentiel flottant, libre de potentiel, lors du fonctionnement du dispositif de communication en champ proche dans le mode de communication.
